# EUROPÄISCHE PATENTSCHRIFT

(11) **EP 0 988 129 B1**
(45) Veröffentlichungstag und Bekanntmachung des Hinweises auf die Patenterteilung: **22.01.2003**
(21) Anmeldenummer: 98934870.1
(22) Anmeldetag: 08.06.1998
(51) Int. Cl.: B23K 1/018, B23K 3/06

(54) **VERFAHREN UND VORRICHTUNG ZUR REPARATUR DEFEKTER LOTVERBINDUNGSSTELLEN**
METHOD AND DEVICE FOR REPAIRING DEFECTIVE SOLDERED JOINTS
PROCEDE ET DISPOSITIF POUR REPARER DES SOUDURES DEFECTUEUSES

(30) Priorität: 13.06.1997 DE 19725255
(43) Veröffentlichungstag der Anmeldung: 29.03.2000
(73) Patentinhaber: Pac Tech - Packaging Technologies GmbH, 14641 Nauen (DE)
(72) Erfinder: KASULKE, Paul, D-10551 Berlin (DE)
(74) Vertreter: Tappe, Hartmut
(86) Internationale Anmeldenummer: DE9801552
(87) Internationale Veröffentlichungsnummer: WO98057774

(56) Entgegenhaltungen:
- WO-A-97/12714
- DE-A- 4 435 323
- DE-A- 19 541 996
- US-A- 5 478 009

## Beschreibung

Die vorliegende Erfindung betrifft ein Verfahren zur Reparatur fehlerhafter Lotverbindungsstellen gemäß dem Anspruch 1 sowie eine Vorrichtung zur Reparatur fehlerhafter Lotverbindungsstellen mit einer Lotmaterialhandhabungseinrichtung und einer Lotmaterialvereinzelungseinrichtung gemäß dem Oberbegriff des Anspruchs 4. Diese Gattung ist der WO-A-9 712 714 zu entnehmen.

Bei der industriellen Fertigung von Bauelementen in der Mikroelektronik, wie beispielsweise Wafern, Multichipmodulen und auch sogenannten "Chip-Size-Packages", werden diese Bauelemente in Vorbereitung einer nachfolgenden Kontaktierung mit weiteren Bauelementen oder Trägerplantinen auf einer an deren Oberfläche vorgesehenen Anschlußflächenverteilung mit Lotmaterialdepots versehen. Zur Erzeugung der Lotmaterialdepots werden Vorrichtungen verwendet, die vereinzelte Lotmaterialeinheiten auf durch die einzelnen Anschlußflächen der Anschlußflächenverteilung gebildete Lotmaterialträger aufbringen und eine Verbindung der Lotmaterialeinheiten mit der jeweiligen Anschlußfläche herstellen.

Eine solche Vorrichtung ist beispielsweise aus der DE 195 41 996 bekannt, die eine Lotmaterialvereinzelungseinrichtung zur Erzeugung vereinzelter Lotmaterialeinheiten mit einer Lotmaterialapplikationseinrichtung zur Applikation und Verbindung von Lotmaterialeinheiten auf den Anschlußflächen zeigt.

Aufgrund statistischer Unregelmäßigkeiten in den Verfahrensparametern und geringsten geometrischen Abweichungen in der Zuordnung zwischen der Lotmaterialapplikationseinrichtung und dem Lotmaterialträger oder auch durch die Oberflächengeometrie des Lotmaterialträgers bedingt kommt es bei der Durchführung derartiger Verfahren zur Erzeugung von Lotmaterialdepots immer wieder zu fehlerhaft ausgebildeten Lotmaterialdepots. Hierbei reicht die Bandbreite der Fehlermöglichkeiten von dem völligen Fehlen eines Lotmaterialdepots auf einer Anschlußfläche bis hin zur Ausbildung von Kurzschlüssen zwischen benachbarten Lotmaterialdepots. Bislang ist das Auftreten derartiger Fehler bei der Erzeugung von Lotmaterialdepots regelmäßig gleichbedeutend mit der Aussonderung der entsprechenden Bauelemente als Ausschuß.

Aus der WO-A-97/12714 ist ein Verfahren bzw. eine Vorrichtung bekannt, die zur Reparatur fehlerhafter Lotverbindungsstellen eingesetzt werden kann, und bei dem neben einer Handhabungseinrichtung zur Applikation eines Bauelements auf einem Substrat, die gleichzeitig zum Aufschmelzen einer Lotverbindung eingesetzt wird, der Einsatz weiterer separater Einrichtungen empfohlen wird, um Lotmaterial zur Kontaktierung des Bauelements auf dem Substrat zu applizieren bzw. zu entfernen.

Der vorliegenden Erfindung liegt daher die Aufgabe zugrunde, ein Verfahren bzw. eine zur Durchführung eines derartigen Verfahrens geeignete Vorrichtung vorzuschlagen, das bzw. die die Reparatur fehlerhafter Lotmaterialdepots vereinfacht.

Zur Lösung dieser Aufgabe weist das erfindungsgemäße Verfahren die Merkmale des Anspruchs 1 auf.

Bei dem erfindungsgemäßen Verfahren zur Reparatur fehlerhafter Lotverbindungsstellen wird in einem ersten Verfahrensschritt eine Lotmaterialhandhabungseinrichtung mit einer Lotmaterialabnahmeeinrichtung an einer Lotmaterialfehlstelle plaziert und ein fehlerhaftes Lotmaterialdepot aus der Verbindung mit einem Lotmaterialträger gelöst und abgenommen. In einem zweiten Verfahrensschritt wird eine Lotmaterialeinheit mit einer an der Lotmaterialfehlstelle plazierten Lotmaterialapplikationseinrichtung der Lotmaterialhandhabungseinrichtung auf den Lotmaterialträger aufgebracht und mit dem Lotmaterialträger verbunden.

Erfindungsgemäß wird zur Ausbildung der Lotmaterialabnahmeeinrichtung und zur Ausbildung der Lotmaterialapplikationseinrichtung ein und dieselbe Lotmaterialhandhabungseinrichtung in zwei unterschiedlichen Funktionsarten betrieben wird. Hierdurch entfällt die Notwendigkeit, zur Durchführung des erfindungsgemäßen Verfahrens die Lotmaterialabnahmeeinrichtung und die Lotmaterialapplikationseinrichtung als separate Einrichtungen bereitzustellen. Vielmehr können beide Funktionen von einer einzigen Einrichtung durchgeführt werden.

Zur Ausbildung der Lotmaterialabnahmeeinrichtung wird die Lotmaterialhandhabungseinrichtung zunächst in einem Aufschmelzmodus zum Lösen der Verbindung des Lotmaterialdepots mit dem Lotmaterialträger und anschließend zur Abnahme des Lotmaterialdepots vom Lotmaterialträger in einem Handhabungsmodus b'etrieben.

Zur Ausbildung der Lotmaterialapplikationseinrichtung wird die Lotmaterialhandhabungseinrichtung zunächst in einem Handhabungsmodus zur Applikation einer Lotmaterialeinheit auf dem Lotmaterialträger und anschließend zur Verbindung der Lotmaterialeinheit mit dem Lotmaterialträger in einem Aufschmelzmodus betrieben.

Als besonders vorteilhaft erweist es sich, wenn die Lösung der Verbindung des Lotmaterialdepots mit dem Lotmaterialträger und die Verbindung der Lotmaterialeinheit mit dem Lotmaterialträger mittels einer Beaufschlagung des Lotmaterialdepots bzw. der Lotmaterialeinheit mit Laserenergie erfolgt. Hierdurch ist eine gezielte Einbringung der für das Aufschmelzen benötigten Energie ohne unnötig hohe Erwärmung der die Lotverbindungsstelle umgebenden Bereiche möglich.

Gemäß einer bevorzugten Variante des erfindungsgemäßen Verfahrens erfolgt die Abnahme des Lotmaterialdepots vom Lotmaterialträger mittels Unterdruck und die Applikation der Lotmaterialeinheit auf dem Lotmaterialträger mittels Überdruck. Hierdurch ist es möglich, sowohl zur Abnahme als auch zur Applikation des Lotmaterials ein und dasselbe Medium einzusetzen. Als besonders vorteilhaft erweist sich in diesem Zusammenhang die Verwendung eines Gases, insbesondere eines Schutzgases.

Eine zur Durchführung des erfindungsgemäßen Verfahrens besonders geeignete erfindungsgemäße Vorrichtung weist die Merkmale des Anspruchs 4 auf.

Die erfindungsgemäße Vorrichtung zur Reparatur fehlerhafter Lotverbindungsstellen umfaßt eine Lotmaterialhandhabungseinrichtung und eine Lotmaterialvereinzelungseinrichtung, wobei die Lotmaterialhandhabungseinrichtung eine Lotmaterialabnahmeeinrichtung zum Lösen und Abnehmen eines Lotmaterialdepots aus einer Verbindung mit einem Lotmaterialträger und eine Lotmaterialapplikationseinrichtung zur Applikation und Verbindung einer Lotmaterialeinheit mit dem Lotmaterialträger aufweist.

Die erfindungsgemäße Vorrichtung vereinigt sämtliche Einrichtungen, die sowohl zur Abnahme fehlerhafter Lotdepots als zur Applikation von Lotmaterialeinheiten notwendig sind. Demnach kann die erfindungsgemäße Vorrichtung in besonders vorteilhafter Weise konventionelle Lotmaterialapplikationseinrichtungen, die zur Erzeugung von Lotmaterialdepots auf Anschlußflächenverteilungen dienen, ersetzen und lediglich im Bedarfsfall in ihrer Eigenschaft als Reparatureinrichtung eingesetzt werden. Hierdurch ist mit dem Einsatz der erfindungsgemäßen Vorrichtung nicht die Installation einer weiteren Vorrichtung bei der Durchführung eines Verfahrens zur Erzeugung von Lotmaterialdepots notwendig, sondern ein und dieselbe Vorrichtung kann sowohl zur Erzeugung der Lotmaterialdepots als auch zur Reparatur fehlerhafter Lotmaterialdepots verwendet werden.

Erfindungsgemäß sind sowohl die Lotmaterialabnahmeeinrichtung als auch die Lotmaterialapplikationseinrichtung durch ein und dieselbe bauliche Anordnung von Funktionsteilen der Lotmaterialhandhabungseinrichtung gebildet. Hierdurch entfällt die Notwendigkeit, die Lotmaterialabnahmeeinrichtung und die Lotmaterialapplikationseinrichtung als einzelne und separat voneinander ausgebildete Einrichtungen bereitzustellen. Vielmehr werden die unterschiedlichen Funktionen beider Einrichtungen durch ein und dieselbe bauliche Anordnung ermöglicht. Eine derartige Vorrichtung zeichnet sich demnach durch ein besonders geringes Bauvolumen aus.

Erfindungsgemäß weist die Lotmaterialabnahmeeinrichtung bzw. die Lotmaterialapplikationseinrichtung zum Lösen der Verbindung des Lotmaterialdepots mit dem Lotmaterialträger bzw. zur Herstellung der Verbindung der Lotmaterialeinheit mit dem Lotmaterialträger eine Aufschmelzeinrichtung auf. Dabei erweist es sich als besonders vorteilhaft, zur Ausbildung der Aufschmelzeinrichtung eine Lasereinrichtung zu verwenden, da die Lasereinrichtung einen berührungsfreien Energieeintrag in das Lotmaterialdepot bzw. die Lotmaterialeinheit bei gleichzeitiger Ausbildung eines ausreichenden Abstands der Lasereinrichtung von der Verbindungsstelle ermöglicht, so daß dieser Abstand zur zwischenliegenden Anordnung weiterer Funktionsteile genutzt werden kann.

Als besonders vorteilhaft erweist es sich ferner, wenn die Lotmaterialabnahmeeinrichtung und die Lotmaterialapplikationseinrichtung zur Abnahme des Lotmaterialdepots vom Lotmaterialträger bzw. zur Applikation der Lotmaterialeinheit auf dem Lotmaterialträger ein mit einem Gasdruck beaufschlagbares Kapillarmundstück aufweist. Hierdurch ist die Ausbildung der Lotmaterialabnahmeeinrichtung sowie der Lotmaterialapplikationseinrichtung mit geringstmöglichem apparativen Aufwand möglich.

Zudem bietet sich der Vorteil, ein derartiges Kapillarmundstück ohne weiteres in dem vorstehend erörterten Abstand zwischen der Lotmaterialverbindungsstelle und der als Lasereinrichtung ausgeführten Aufschmelzeinrichtung unterzubringen.

Das vorstehend erwähnte, mit einem Gasdruck beaufschlagbare Kapillarmundstück ist durch einfache Differenzierung zwischen einem Unterdruckbetrieb und einem Überdruckbetrieb von einer Funktion als Lotmaterialabnahmeeinrichtung in eine Funktion als Lotmaterialapplikationseinrichtung und umgekehrt überführbar. Hierzu kann das Kapillarmundstück zur Abnahme des Lotmaterialdepots vom Lotmaterialträger mit Unterdruck und zur Applikation der Lotmaterialeinheit auf dem Lotmaterialträger mit Überdruck beaufschlagt werden.

Bevorzugt wird auch eine Ausführungsform, in der die Lotmaterialhandhabungseinrichtung mit der Lotmaterialvereinzelungseinrichtung modular koppelbar ist. Hierdurch ist es beispielsweise möglich, ein und dieselbe Lotmaterialhandhabungseinrichtung mit unterschiedlichen Lotmaterialvereinzelungseinrichtungen zu koppeln, je nachdem, wie die Lotmaterialeinheiten zur Erzeugung der Lotmaterialdepots beschaffen sein sollen.

Bevorzugt wird auch, wenn die Kopplung der Lotmaterialhandhabungseinrichtung mit der Lotmaterialvereinzelungseinrichtung über eine zwischen der Lasereinrichtung und dem Kapillarmundstück angeordnete Koppeleinrichtung erfolgt. Abgesehen von einer möglichst einfachen Durchführung der Kopplung zwischen der Lotmaterialhandhabungseinrichtung und der Lotmaterialvereinzelungseinrichtung, ist es auch möglich, die Koppeleinrichtung gleichzeitig als Zuführeinrichtung zur Zuführung von Lotmaterialeinheiten aus der Lotmaterialvereinzelungseinrichtung zum Kapillarmundstück zu verwenden.

Nachfolgend wird eine bevorzugte Variante des erfindungsgemäßen Verfahrens unter Darstellung einer hierzu geeigneten Vorrichtung anhand der Zeichnungen näher erläutert. Es zeigen:
**Fig. 1** die Abnahme eines auf einem Lotmaterialträger angeordneten Lotdepots mittels einer Lotmaterialhandhabungseinrichtung in der Funktions als Lotmaterialabnahmeeinrichtung;
**Fig. 2** die Applikation einer Lotmaterialeinheit mittels der in **Fig. 1** dargestellten Lotmaterialhandhabungseinrichtung in der Funktion als Lotmaterialapplikationseinrichtung;
**Fig. 3** eine Möglichkeit einer konstruktiven Ausführung der in dem Verfahren zur Reparatur von Lotmaterialverbindungsstellen gemäß **Fig. 1 und 2** verwendeten Lotmaterialhandhabungseinrichtung;
**Fig. 4** eine Darstellung der in **Fig. 3** dargestellten Lotmaterialhandhabungseinrichtung in Draufsicht;
**Fig. 5** eine alternative Ausführung einer Vorrichtung zur Reparatur fehlerhafter Lotverbindungsstellen in Draufsicht.

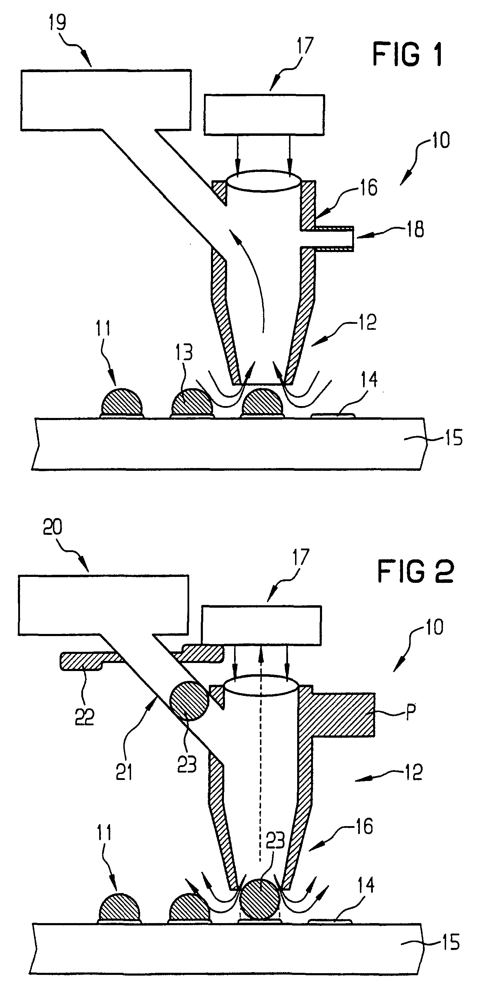

**Fig. 1** zeigt in schematischer Darstellung eine Reparaturvorrichtung 10 zur Reparatur defekter Lotverbindungsstellen 11 mit einer Lotmaterialhandhabungseinrichtung 12 in der hier dargestellten Funktion als Lotmaterialabnahmeeinrichtung bei einem ersten Verfahrensschritt des nachfolgend erläuterten Verfahrens zur Reparatur defekter Lotverbindungsstellen 11.

Bei dem in **Fig. 1** dargestellten ersten Verfahrensschritt der Entfernung bzw. Abnahme von Lotmaterialdepots 13 von Lotmaterialträger bildenden Bumps 14, die in einer hier nicht näher dargestellten Anschlußflächenverteilung auf der Kontaktoberfläche eines hier als Chip 15 ausgeführten elektronischen Bauelements angeordnet sind, wird, wie **Fig. 1** zeigt, zunächst die Lotmaterialhandhabungseinrichtung 12 mit ihrem Kapillarmundstück 16 über der Lotverbindungsstelle 11 plaziert. Mittels einer Lasereinrichtung 17 der Lotmaterialhandhabungseinrichtung 12 wird nunmehr die Lotverbindungsstelle 11 mit Laserenergie beaufschlagt, derart, daß ein Aufschmelzen des auf dem Bump 14 angeordneten Lotmaterialdepots 13 erfolgt. Über einen hier am Kapillarmundstück 16 der Lotmaterialhandhabungseinrichtung 12 vorgesehenen Druckanschluß 18 erfolgt nunmehr eine Unterdruckbeaufschlagung des Lotmaterialdepots 13. Infolge des Aufschmelzvorgangs wird das Lotmaterialdepot 13 nur noch durch die zwischen dem flüssigen Lotmaterial und dem Lotmaterialträger ausgebildeten Benetzungskräfte gehalten und kann durch Unterdruck vom Bump 14 abgenommen und in einen mit dem Kapillarmundstück 16 in Verbindung stehenden Sammelbehälter 19 überführt werden.

**Fig. 2** zeigt die Lotmaterialhandhabungseinrichtung 12 in ihrer Funktion als Lotmaterialapplikationseinrichtung, wobei hier die Lotmaterialhandhabungseinrichtung 12 in einem dem in **Fig. 1** dargestellten Verfahrensschritt nachfolgenden Verfahrensschritt eingesetzt wird und daher nach Abnahme des Lotmaterialdepots 13 gemäß **Fig. 1** in der der betreffenden Lotverbindungsstelle 11 zugeordneten Plazierung verbleibt. Die Überführung der Lotmaterialhandhabungseinrichtung 12 von der in **Fig. 1** dargestellten Funktion als Lotmaterialabnahmeeinrichtung in die in **Fig. 2** dargestellte Funktion als Lotmaterialapplikationseinrichtung erfolgt durch einfache Umschaltung des Druckanschlusses 18 von einem Unterdruckbetrieb in einen Überdruckbetrieb. Zudem ist die Lotmaterialhandhabungseinrichtung 12 in ihrer Funktion als Lotmaterialapplikationseinrichtung nunmehr mit einer Lotmaterialvereinzelungseinrichtung 20 gekoppelt. Hierzu steht in der in **Fig. 2** schematisch ausgeführten Darstellung das Kapillarmundstück 16 über einen Zuführkanal 21 in Verbindung mit einer Übergabeeinrichtung 22 der Lotmaterialvereinzelungseinrichtung 20.

Die Applikation einer Lotmaterialeinheit 23 aus der Lotmaterialvereinzelungseinrichtung 20 erfolgt durch Übergabe der Lotmaterialeinheit 23 durch den Zuführkanal 21 in das Kapillarmundstück 16 und Beaufschlagung der Lotmaterialeinheit 23 mit Überdruck zur Herstellung eines möglichst spaltfreien mechanischen Kontakts zwischen der Lotmaterialeinheit 23 und dem Bump 14. In dieser Stellung erfolgt dann die Beaufschlagung der Lotmaterialeinheit 23 mit von der Lasereinrichtung 17 emittierter Laserenergie zur Herstellung einer Lotverbindung und Erzeugung einer Lotverbindungsstelle 11. Dabei kann, wie in **Fig. 2** durch den mit punktierter Linienführung eingezeichneten Pfeil dargestellt, die Aktivierung der Lasereinrichtung 17 durch ein Detektorsignal, beispielsweise ausgelöst durch einen optischen Sensor, erfolgen, der die korrekte Applikation der Lotmaterialeinheit 23 auf dem Bump 14 erfaßt.

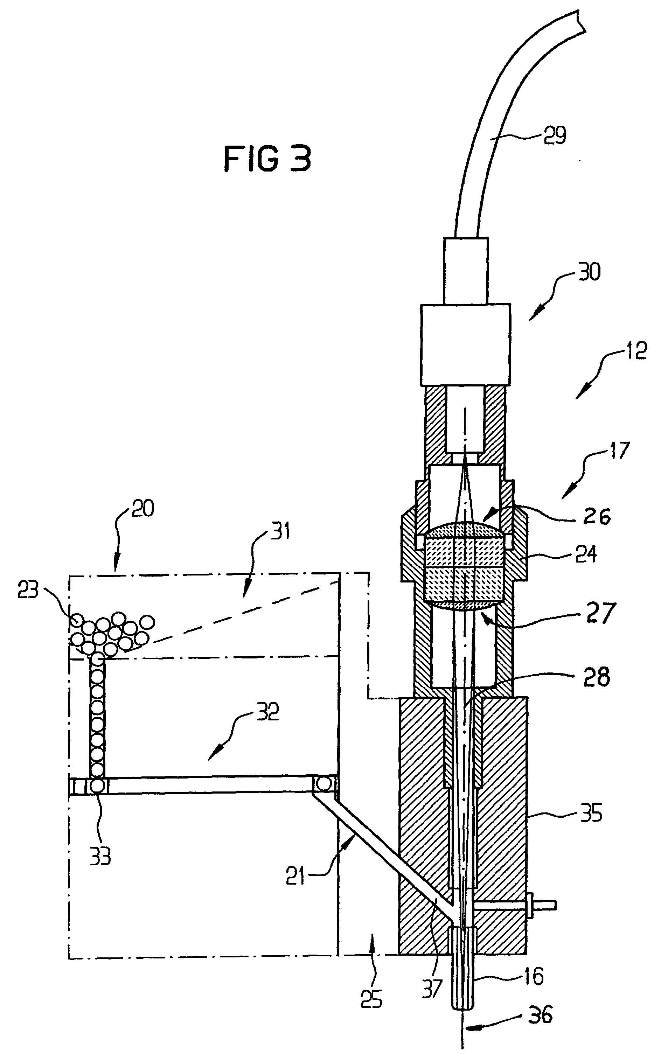

Sowohl die in dem in **Fig. 1** dargestellten Verfahrensschritt erfolgende Unterdruckbeaufschlagung der Lotverbindungsstelle 11 als auch die gemäß dem in **Fig. 2** dargestellten Verfahrensschritt erfolgende Überdruckbeaufschlagung der Lotverbindungsstelle 11 bzw. der Lotmaterialeinheit 23 kann mittels einer inerten Gases - beispielsweise auch unter Verwendung von Stickstoff - und auch während der Beaufschlagung der Lotverbindungstelle 11 bzw. der Lotmaterialeinheit 23 mit Laserenergie durch die Lasereinrichtung 17 erfolgen, so daß zum einen die Erzeugung von Lotverbindungsstellen möglich ist, die weitestgehend frei von Oxydationsrückständen sind und zum anderen ein unerwünschter Niederschlag infolge von Dampfbildung beim Aufschmelzen des Lotmaterials auf eine in **Fig. 3** dargestellte optischen Anordnung 24 der Lasereinrichtung 17 verhindert wird. Die Gasbeaufschlagung der Lotmaterialdepots 13 bzw. der Lotmaterialeinheit 23 zu deren Transport innerhalb des Kapillarmundstücks 16 kann unmittelbar durch das Kapillarmundstück 16 erfolgen. Die Gasbeaufschlagung zur Abschirmung der Lotverbindungsstelle 11 bzw. der optischen Anordnung 24 kann über eine am Kapillarmundstück 16 ausgebildete, hier nicht näher dargestellte Ringdüse erfolgen.

**Fig. 3** zeigt eine mögliche Ausführung der in den **Fig. 1 und 2** in unterschiedlichen Verfahrensschritten dargestellte Reparaturvorrichtung 10. In dem in **Fig. 3** dargestellten Ausführungsbeispiel ist die Lotmaterialhandhabungseinrichtung 12 mit der Lotmaterialvereinzelungseinrichtung 20 mittels einer Koppeleinrichtung 25 gekoppelt. Gleichzeitig dient das Koppelelement 25 zur Verbindung des Kapillarmundstücks 16 mit der Lasereinrichtung 17, die die bereits vorstehend erwähnte optische Anordnung 24 aufweist. Die optische Anordnung 24 weist im vorliegenden Fall ein Linsensystem umfassend eine Kollimatorlinse 26 und eine Sammellinse 27 auf, wobei die optische Anordnung 24 derart justiert ist, daß, wie durch einen in **Fig. 3** eingezeichneten Strahlengang 28 längs einer optischen Achse 36 angedeutet, eine Fokussierung des Strahlengangs 28 im Bereich der in **Fig. 3** nicht dargestellten Verbindungsstelle erfolgt.

Der Anschluß an eine entfernt von der Lasereinrichtung 17 angeordnete Laserquelle an die Lasereinrichtung 17 erfolgt hier über einen Glasfaserleiter 29, der über einen Steckeranschluß 30 mit der Lasereinrichtung 17 verbunden ist.

Bei dem in **Fig. 3** dargestellten Ausführungsbeispiel umfaßt die Lotmaterialvereinzelungseinrichtung 20 einen Vorratsbehälter 31, in dem stückige Lotmaterialeinheiten 23 angeordnet,die über einen mit einem Lochteilkreis versehenen Kreisförderer 32 in Förderlöchern 33 aufgenommen an den in der Koppeleinrichtung 25 ausgebildeten Zuführkanal 21 vereinzelt auf Abruf übergeben werden.

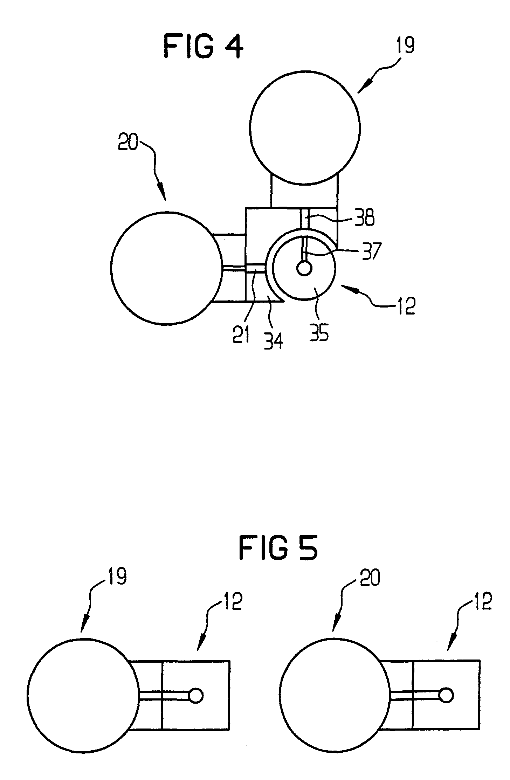

In dem in **Fig. 3** dargestellten Ausführungsbeispiel ist die Koppeleinrichtung 25 aus einem feststehenden, mit der Lotmaterialvereinzelungseinrichtung 20 verbundenen **Anschlußteil** 34 und einem am Anschlußteil 34 schwenkbar gelagerten Schwenkteil 35 gebildet, wobei das Schwenkteil 35 eine drehfeste Verbindung zwischen der Lasereinrichtung 17 und dem Kapillarmundstück 16 herstellt. Die in **Fig. 3** dargestellte Anordnung ermöglicht es, über eine Veränderung der Schwenkstellung des Schwenkteils 35 gegenüber dem Anschlußteil 34 durch Verschwenken um eine mit der optischen Achse 36 im wesentlichen identische Schwenkachse die Lotmaterialhandhabungseinrichtung 12 von der in **Fig. 3** dargestellten Schwenkstellung, in der die Lotmaterialhandhabungseinrichtung 12 die Funktion der Lotmaterialapplikationseinrichtung hat, in eine zweite, in **Fig. 4** dargestellte Schwenkstellung zu überführen. In dieser zweiten Schwenkstellung ist über ein im Schwenkteil 35 ausgebildetes Zuführkanalteilstück 37 das Schwenkteil 35 nicht mit dem in die Lotmaterialvereinzelungseinrichtung 20 einmündenden Zuführkanal 21 verbunden, sondern vielmehr mit einem in **Fig. 4** dargestellten Zuführkanal 38 verbunden, der über das Anschlußteil 34 in den Sammelbehälter 19 einmündet.

Entgegen der Darstellung in den **Fig. 3** und **4** ist es auch möglich, eine Lotmaterialhandhabungseinrichtung mit jeweils zwei einander zugeordneten , auf einer gemeinsamen optischen Achse angeordneten Kapillarmundstücken und optischen Anordnungen zu versehen, so daß eine erste Einheit aus einem ersten Kapillarmundstück und einer ersten optischen Anordnung zur Ausbildung der Lotmaterialabnahmeeinrichtung dient und eine zweite Einheit aus einem zweiten Kapillarmundstück und einer zweiten optischen Anordnung zur Ausbildung der Lotmaterialapplikationseinrichtung dient. Beide Einheiten können dann durch Umschaltung eines aus einer Laserquelle emittierten Strahlengangs - beispielsweise mittels eines Klappspiegels - von einer einzigen Laserquelle mit Laserenergie beaufschlagt werden.

**Fig. 5** zeigt schließlich eine Anordnung bzw. Ausführung einer Reparaturvorrichtung 39, bei der zwei Lotmaterialhandhabungseinrichtungen 12 vorgesehen sind, die in einem Fall als Lotmaterialabnahmeeinrichtung ausgebildet mit einem Sammelbehälter 19 verbunden und im anderen Fall als Lotmaterialapplikationseinrichtung ausgebildet mit einer Lotmaterialvereinzelungseinrichtung 20 verbunden sind und bei dem vorstehend erläuterten Verfahren zur Reparatur von fehlerhaften Lotverbindungsstellen parallel zum Einsatz kommen.

## Patentansprüche

1. Verfahren zur Reparatur fehlerhafter Lotverbindungsstellen (11), bei dem in einem ersten Verfahrensschritt eine Lotmaterialhandhabungseinrichtung (12) mit einer Lotmaterialabnahmeeinrichtung an einer Lotmaterialfehlstelle plaziert wird und ein fehlerhaftes Lotmaterialdepot (13) aus der Verbindung mit einem Lotmaterialträger (14) gelöst und abgenommen wird, und bei dem in einem zweiten Verfahrensschritt eine Lotmaterialeinheit (23) aus einer an der Lotmaterialfehlstelle plazierten Lotmaterialapplikationseinrichtung der Lotmaterialhandhabungseinrichtung (12) auf den Lotmaterialträger (14) aufgebracht und mit dem Lotmaterialträger verbunden wird,
**dadurch gekennzeichnet,**
**daß** zur Ausbildung der Lotmaterialabnahmeeinrichtung und zur Ausbildung der Lotmaterialapplikationseinrichtung ein und dieselbe Lotmaterialhandhabungseinrichtung (12) in zwei unterschiedlichen Funktionsarten betrieben wird, derart daß zur Ausbildung der Lotmaterialabnahmeeinrichtung die Lotmaterialhandhabungseinrichtung (12) zunächst in einem Aufschmelzmodus zum Lösen der Verbindung des Lotmaterialdepots (13) mit dem Lotmaterialträger (14) und anschließend zur Abnahme des Lotmaterialdepots vom Lotmaterialträger in einem Handhabungsmodus betrieben wird, und derart, daß zur Ausbildung der Lotmaterialapplikationseinrichtung die Lotmaterialhandhabungseinrichtung (12) zunächst in einem Handhabungsmodus zur Applikation einer Lotmaterialeinheit (23) auf dem Lotmaterialträger (14) und anschließend zur Verbindung der Lotmaterialeinheit (23) mit dem Lotmaterialträger in einem Aufschmelzmodus betrieben wird.

2. Verfahren nach einem oder mehreren der vorangehenden Ansprüche,
**dadurch gekennzeichnet,**
**daß** die Lösung der Verbindung des Lotmaterialdepots (13) mit dem Lotmaterialträger (14) und die Verbindung der Lotmaterialeinheit (23) mit dem Lotmaterialträger (14) mittels einer Beaufschlagung des Lotmaterialdepots bzw. der Lotmaterialeinheit mit Laserenergie erfolgt.

3. Verfahren nach Anspruch 1 oder 2,
**dadurch gekennzeichnet,**
**daß** die Abnahme des Lotmaterialdepots (13) vom Lotmaterialträger (14) mittels Unterdruck und die Applikation der Lotmaterialeinheit (23) auf dem Lotmaterialträger (14) mittels Überdruck erfolgt.

4. Vorrichtung zur Reparatur fehlerhafter Lotverbindungsstellen mit einer Lotmaterialhandhabungseinrichtung (12) und einer Lotmaterialvereinzelungseinrichtung, wobei die Lotmaterialhandhabungseinrichtung eine Lotmaterialabnahmeeinrichtung zum Lösen und Abnehmen eines Lotmaterialdepots (13) aus einer Verbindung mit einem Lotmaterialträger (14) und eine Lotmaterialapplikationseinrichtung zur Applikation und Verbindung einer Lotmaterialeinheit (23) mit dem Lotmaterialträger (14) aufweist,
**dadurch gekennzeichnet,**
**daß** die Lotmaterialabnahmeeinrichtung und die Lotmaterialapplikationseinrichtung durch ein und dieselbe bauliche Anordnung von Funktionsteilen der Lotmaterialhandhabungseinrichtung (12) gebildet sind, wobei die Lotmaterialabnahmeeinrichtung und die Lotmaterialapplikationseinrichtung zum Lösen der Verbindung des Lotmaterialdepots (13) mit dem Lotmaterialträger (14) bzw. zur Herstellung der Verbindung der Lotmaterialeinheit (23) mit dem Lotmaterialträger eine Aufschmelzeinrichtung aufweisen.

5. Vorrichtung nach Anspruch 4,
**dadurch gekennzeichnet,**
**daß** die Aufschmelzeinrichtung durch eine Lasereinrichtung (17) gebildet ist.

6. Vorrichtung nach Anspruch 4 oder 5,
**dadurch gekennzeichnet,**
**daß** die Lotmaterialabnahmeeinrichtung und die Lotmaterialapplikationseinrichtung zur Abnahme des Lotmaterialdepots (13) vom Lotmaterialträger (14) bzw. zur Applikation der Lotmaterialeinheit (23) auf dem Lotmaterialträger ein mit einem Gasdruck beaufschlagbares Kapillarmundstück (16) aufweist.

7. Vorrichtung nach Anspruch 6,
**dadurch gekennzeichnet,**
**daß** das Kapillarmundstück (16) zur Abnahme des Lotmaterialdepots (13) vom Lotmaterialträger (14) mit Unterdruck und zur Applikation der Lotmaterialeinheit (23) auf dem Lotmaterialträger mit Überdruck beaufschlagbar ist.

8. Vorrichtung nach einem oder mehreren der Ansprüche 4 bis 7,
**dadurch gekennzeichnet,**
**daß** die Lotmaterialhandhabungseinrichtung (12) mit der Lotmaterialvereinzelungseinrichtung (20) modular koppelbar ist.

9. Vorrichtung nach Anspruch 8,
**dadurch gekennzeichnet,**
**daß** die Kopplung der Lotmaterialhandhabungseinrichtung (12) mit der Lotmaterialvereinzelungseinrichtung (20) über eine zwischen der Lasereinrichtung (17) und dem Kapillarmundstück (16) angeordnete Koppeleinrichtung (35) erfolgt.

## Claims

1. Method for repairing defective soldered joints (11), in which in a first method step a soldering material handling device (12) is placed at a soldering material defect point with a soldering material removal device and a defective soldering material deposit (13) is loosened from the connection with a soldering material carrier (14) and removed, and in which in a second method step a soldering material unit (23) is applied to the soldering material carrier (14) and connected to the soldering material carrier out of a soldering material application device of the soldering material handling device (12), said soldering material application device being placed at the soldering material defect point,
**characterised in that**
in order to form the soldering material removal device and in order to form the soldering material application device one and the same soldering material handling device (12) is operated in two different types of function, in such a way that in order to form the soldering material removal device the soldering material handling device (12) is first of all operated in a melting mode for loosening the connection of the soldering material deposit (13) with the soldering material carrier (14) and then in a handling mode for removing the soldering material deposit from the soldering material carrier, and in such a way that, in order to form the soldering material application device the soldering material handling device (12) is operated first of all in a handling mode for applying a soldering material unit (23) to the soldering material carrier (14) and then in a melting mode for connecting the soldering material unit (23) to the soldering material carrier.

2. Method according to one or more of the preceding claims,
**characterised in that**
the loosening of the connection of the soldering material deposit (13) with the soldering material carrier (14) and the connection of the soldering material unit (23) to the soldering material carrier (14) takes place by means of an exposure of the soldering material deposit or the soldering material unit to laser energy.

3. Method according to claim 1 or 2,
**characterised in that**
the removal of the soldering material deposit (13) from the soldering material carrier (14) takes places by means of reduced pressure and the application of the soldering material unit (23) to the soldering material carrier (14) by means of excess pressure.

4. Apparatus for repairing defective soldered joints with a soldering material handling device (12) and a soldering material isolating device, wherein the soldering material handling device comprises a soldering material removal device for loosening and removing a soldering material deposit (13) from a connection with a soldering material carrier (14) and a soldering material application device for applying and connecting a soldering material unit (23) to the soldering material carrier (14),
**characterised in that**
the soldering material removal device and the soldering material application device are formed by one and the same structural arrangement of functional parts of the soldering material handling device (12), wherein the soldering material removal device and the soldering material application device comprise a melting device for loosening the connection of the soldering material deposit (13) with the soldering material carrier (14) or for producing the connection of the soldering material unit (23) with the soldering material carrier.

5. Apparatus according to claim 4,
**characterised in that**
the melting device is formed by a laser device (17).

6. Apparatus according to claim 4 or 5,
**characterised in that**
the soldering material removal device and the soldering material application device comprise a capillary mouthpiece (16) subjectable to a gas pressure for removing the soldering material deposit (13) from the soldering material carrier (14) or for applying the soldering material unit (23) to the soldering material carrier.

7. Apparatus according to claim 6,
**characterised in that**
the capillary mouthpiece (16) is subjectable to reduced pressure for removing the soldering material deposit (13) from the soldering material carrier (14) and to excess pressure for applying the soldering material unit (23) to the soldering material carrier.

8. Apparatus according to one or more of claims 4 to 7,
**characterised in that**
the soldering material handling device (12) is couplable module-wise with the soldering material isolating device (20).

9. Apparatus according to claim 8,
**characterised in that** the coupling of the soldering material handling device (12) with the soldering material isolating device (20) takes place via a coupling device (35) arranged between the laser device (17) and the capillary mouthpiece (16).

## Revendications

1. Procédé de réparation de jonctions par brasage défectueuses (11) dans lequel, dans une première étape de procédé, un dispositif (12) de maniement de matériau de brasage comportant un dispositif d'enlèvement de matériau de brasage est placé à une jonction défectueuse de matériau de brasage et un dépôt (13) de matériau de brasage défectueux est détaché de la liaison avec un support (14) de matériau de brasage et enlevé, et dans lequel, dans une deuxième étape de procédé, une unité (23) de matériau de brasage provenant d'un dispositif d'application de matériau de brasage du dispositif (12) de maniement de matériau de brasage placé à l'endroit défectueux du matériau de brasage est répandue sur le support (14) de matériau de brasage et reliée au support de matériau de brasage,
**caractérisé en ce que** pour la formation du dispositif d'enlèvement de matériau de brasage et pour la formation du dispositif d'application de matériau de brasage, on utilise un seul et même dispositif (12) de maniement de matériau de brasage dans deux types de fonctionnement différents, de telle manière que, pour la formation du dispositif d'enlèvement de matériau de brasage, on utilise le dispositif (12) de maniement de matériau de brasage, tout d'abord selon un mode de fusion, pour défaire la liaison du dépôt (13) de matériau de brasage avec le support (14) de matériau de brasage, et ensuite selon un mode de maniement, pour l'enlèvement du dépôt de matériau de brasage du support de matériau de brasage, et de telle manière que, pour la formation du dispositif d'application de matériau de brasage, on utilise le dispositif (12) de maniement de matériau de brasage, tout d'abord selon un mode de maniement, pour l'application d'une unité (23) de matériau de brasage sur le support (14) de matériau de brasage, et ensuite selon un mode de fusion, pour la liaison de l'unité (23) de matériau de brasage avec le support de matériau de brasage.

2. Procédé selon l'une ou plusieurs des revendications précédentes,
**caractérisé en ce que** la suppression de la liaison du dépôt (13) de matériau de brasage avec le support (14) de matériau de brasage et la liaison de l'unité (23) de matériau de brasage avec le support (14) de matériau de brasage se fait par application d'énergie laser au dépôt de matériau de brasage et à l'unité de matériau de brasage.

3. Procédé selon la revendication 1 ou 2,
**caractérisé en ce que** l'enlèvement du dépôt (13) de matériau de brasage du support (14) de matériau de brasage se fait par dépression et l'application de l'unité de matériau de brasage (23) sur le support (14) de matériau de brasage se fait par surpression.

4. Procédé de réparation de jonctions par brasage défectueuses comportant un dispositif (12) de maniement de matériau de brasage et un dispositif d'isolement de matériau de brasage, le dispositif de maniement de matériau de brasage comportant un dispositif d'enlèvement pour défaire et enlever un dépôt (13) de matériau de brasage d'une liaison avec un support (14) de matériau de brasage et un dispositif d'application de matériau de brasage pour l'application et la liaison d'une unité (23) de matériau de brasage avec le support (14) de matériau de brasage,
**caractérisé en ce que** le dispositif d'enlèvement de matériau de brasage et le dispositif d'application de matériau de brasage sont formés par une seule et même structure de parties fonctionnelles du dispositif (12) de maniement de matériau de brasage, le dispositif d'enlèvement de matériau de brasage et le dispositif d'application de matériau de brasage comportant un dispositif de fusion pour défaire la liaison du dépôt (13) de matériau de brasage avec le support (14) de matériau de brasage et pour réaliser la liaison de l'unité (23) de matériau de brasage avec le support de matériau de brasage.

5. Dispositif selon la revendication 4,
**caractérisé en ce que** le dispositif de fusion est formé par un dispositif à laser (17).

6. Dispositif selon la revendication 4 ou 5,
**caractérisé en ce que** le dispositif d'enlèvement de matériau de brasage et le dispositif d'application de matériau de brasage pour l'enlèvement du dépôt (13) de matériau de brasage du support (14) et pour l'application de l'unité (23) de matériau de brasage sur le support de matériau de brasage comportent un ajutage capillaire (16) qui peut être soumis à une pression de gaz.

7. Dispositif selon la revendication 6,
**caractérisé en ce que** l'ajutage capillaire (16) peut être soumis à une dépression pour l'enlèvement du dépôt (13) de matériau de brasage du support (14) de matériau de brasage et à une surpression pour l'application de l'unité (23) de matériau de brasage sur le support de matériau de brasage.

8. Dispositif selon une ou plusieurs des revendications 4 à 7,
**caractérisé en ce que** le dispositif (12) de maniement de matériau de brasage peut être couplé modulairement avec le dispositif (20) d'isolement de matériau de brasage.

9. Dispositif selon la revendication 8,
**caractérisé en ce que** le couplage du dispositif (12) de maniement de matériau de brasage avec le dispositif (20) d'isolement de matériau de brasage se fait par un dispositif de couplage (35) placé entre le dispositif à laser (17) et l'ajutage capillaire (16).
